# EUROPÄISCHE PATENTSCHRIFT

(11) **EP 1 450 404 B1**
(45) Veröffentlichungstag und Bekanntmachung des Hinweises auf die Patenterteilung: **02.03.2011**
(21) Anmeldenummer: 04000281.8
(22) Anmeldetag: 09.01.2004
(51) Int. Cl.: H01L 23/48

(54) **Anordnung in Druckkontaktierung mit einem Leistungshalbleitermodul**
Assembly in pressure contact with a power semiconductor module
Assemblage en contact à pression avec module semi-conducteur de puissance

(30) Priorität: 18.02.2003 DE 10306643
(43) Veröffentlichungstag der Anmeldung: 25.08.2004
(73) Patentinhaber: SEMIKRON Elektronik GmbH & Co. KG, 90431 Nürnberg (DE)
(72) Erfinder: Göbl, Christian, 90441 Nürnberg (DE); Lederer, Marco, 90453 Nürnberg (DE); Popp, Rainer, 91580 Petersaurach (DE)

(56) Entgegenhaltungen:
- DE-A- 19 630 173
- DE-U- 29 819 349
- US-A- 5 259 781
- US-A- 5 409 419
- US-A- 5 653 379
- US-B1- 6 454 587

## Beschreibung

Die Erfindung beschreibt eine Anordnung in Druckkontaktierung für kompakte Leistungshalbleitermodule. Moderne Ausgestaltungen derartiger Leistungshalbleitermodule mit hoher Leistung bezogen auf ihre Baugröße, die Ausgangspunkt dieser Erfindung sind, sind bekannt aus der DE 196 30 173 C2 oder der DE 199 24 993 C2.

Die DE 196 30 173 C2 offenbart ein Leistungshalbleitermodul zur direkten Montage auf einem Kühlkörper, bestehend aus einem Gehäuse und einem elektrisch isolierenden Substrat welches seinerseits aus einem Isolierstoffkörper mit einer Mehrzahl darauf befindlicher gegeneinander isolierter metallischer Verbindungsbahnen und darauf befindlichen und mit diesen Verbindungsbahnen schaltungsgerecht verbundenen Leistungshalbleiterbauelementen besteht. Die externe elektrische Verbindung zu einer außerhalb des Gehäuses angeordneten Leitplatte erfolgt mittels zumindest teilweise federnd gestalteter Anschlussleiter.

Das Leistungshalbleitermodul weist weiterhin mindestens eine zentral angeordnete Ausnehmung zur Durchführung einer Schraubverbindung auf. Diese dient zusammen mit einem auf der dem Leistungshalbleitermodul abgewandeten Seite der Leiterplatte angeordneten und auf dieser flächig aufliegenden, formstabilen Druckstück der Druckkontaktierung des Moduls. Diese Druckkontaktierung erfüllt gleichzeitig zwei Aufgaben: einerseits die sichere elektrische Kontaktierung der Anschlusselemente mit der Leiterplatte und andererseits die thermische Kontaktierung des Moduls mit einem Kühlkörper, wobei beide Kontaktierungen reversibel sind.

Nachteilig an diesen Leistungshalbleitermodulen nach dem dargestellten Stand der Technik ist, dass das bekannte Druckstück eine Anordnung von weiteren Bauelementen, wie beispielhaft Widerständen, Kondensatoren oder integrierten Schaltungen, auf dem von ihm überdeckten Teil der Leiterplatte nicht gestattet.

Beispielhaft aus der DE 199 24 993 C2 sind weiterhin Leistungshalbleitermodule bekannt, bei denen die Anschlusselemente vom Leistungshalbleitermodul zu einer Leiterplatte als Lötstifte ausgeführt sind. Diese Lötstifte dienen als Steuer- sowie als Lastanschlusselement der elektrischen Verbindung der Leistungshalbleiterbauelemente innerhalb des Leistungsmoduls mit den auf der Leiterplatte angeordneten Zuleitungen. Das Leistungshalbleitermodul kann somit entweder direkt oder, wie in der DE 199 24 993 offenbart, mittels einer Adapterplatine mit einer Leiterplatte verbunden werden. Der thermische Kontakt zwischen dem Leistungshalbleitermodul und einem Kühlkörper wird unabhängig von den elektrischen Kontaktierungen mittels Schraubverbindungen hergestellt.

Nachteilig an der Ausgestaltung derartiger Leistungshalbleitermodule ist, dass zwei unterschiedliche Verbindungstechniken (Schraub- und Lötverbindungen, die in mehreren Arbeitsschritten ausgeführt werden müssen) notwendig sind um das Modul in ein übergeordnetes System zu integrieren. Ein besonderer Nachteil besteht hierbei darin, dass die Kontaktsicherheit der Lötverbindungen über die Lebensdauer nicht gegeben ist und, dass die Lötverbindung einen Austausch des Leistungshalbleitermoduls nicht ohne bedeutenden Aufwand ermöglichen.

Weiterhin ist es aus der US 6,454,587 B1 bekannt bei Bussystemen auf Leitplatten eine Anordnung der Abschlusswiderstände vorzusehen, bei der die Widerstände auf einem eigenen Träger angeordnet sind, dieser Träger in einem Sockel angeordnet ist und mittels einer Druckeinrichtung mit der Leiterplatte drucktechnisch elektrisch leitend verbunden wird. Hierbei sind die Abschlusswiderstände beabstandet voneinander auf dem Träger vorgesehen, ein Druckzwischenstück überdeckt und umschließt diese und wird mittels einer Druckeinrichtung mit Druck beaufschlagt.

Die US 5 653 379 A offenbart den Einsatz von Metallseelen zur Stabilisierung von Keramiksubstraten.

Der vorliegenden Erfindung liegt die Aufgabe zu Grunde eine Anordnung für ein Leistungshalbleitermodul mit zumindest teilweise federnd gestalteten Anschlussleitern zur reversiblen elektrischen Verbindung der Verbindungsbahnen mit einer außerhalb des Gehäuses angeordneten Leiterplatte und mindestens einem formstabilen Druckstück zur Druckkontaktierung der Leiterplatte mit den Anschlussteitern vorzustellen, wobei das Druckstück die gleichzeitige Platzierung von Bauelementen auf der Leiterplatte sowie deren Kühlung zulässt.

Diese Aufgabe wird gelöst durch eine Anordnung nach dem Anspruch 1, spezielle Ausgestaltungen finden sich in den Unteransprüchen.

Der Grundgedanke der Erfindung geht aus von einem Leistungshalbleiterbauelement mit Grundplatte oder zur direkten Montage auf einem Kühlkörper nach dem genannten Stand der Technik bestehend aus einem Gehäuse mit mindestens einem darin angeordneten elektrisch isolierenden Substrat. Dieses Substrat besteht seinerseits aus einem Isolierstoffkörper mit einer Mehrzahl auf seiner ersten Hauptfläche befindlicher gegeneinander isolierter metallischer Verbindungsbahnen sowie vorzugsweise aus einer auf seiner zweiten Hauptfläche angeordneten flächigen metallischen Schicht. Auf den Verbindungsbahnen der ersten Hauptfläche und mit diesen Verbindungsbahnen schaltungsgerecht verbunden sind eine Mehrzahl von Leistungshalbleiterbauelementen angeordnet.

Als Anschlusselemente sowohl für Last- als auch für Steueranschlüsse weist das Leistungshalbleitermodul zumindest teilweise federnd gestaltete Anschlussleiter auf. Diese Anschlussleiter stellen die elektrische Verbindung der Verbindungsbahnen mit einer außerhalb des Gehäuses angeordneten Leiterplatte und den darauf angeordneten externen Verbindungsbahnen her. Der sichere elektrische Kontakt zwischen den Anschlussleitern und den externen Verbindungsbahnen der Leiterplatte wird mittels einer Anordnung zur Druckkontaktierung erzielt. Die Druckeinleitung dieser Anorndung erfolgt mittels mindestens einem mit der Grundplatte oder dem Kühlkörper verbundenen formstabilen Druckstück, wobei diese Verbindung vorzugsweise mittels einer Schraubverbindung hergestellt wird. Es ergibt sich somit ein Aufbau, der aus einem Druckstück, einer Leiterplatte, dem Leistungshalbleitermodul und einer Grundplatte oder einem Kühlkörper besteht.

Die erfindungsgemäße Ausgestaltung des Druckstücks weist an dessen zweiter der Leiterplatte zugewandten Hauptfläche eine Mehrzahl von einzelnen oder miteinander verbundenen Druckelementen auf. Diese Druckelemente beabstanden die zweite Hauptfläche des Druckelements von der Leiterplatte derart, dass auf der ersten, dem Druckstück zugewandten Hauptfläche der Leiterplatte Bauelemente wie beispielhaft Widerstände, Kondensatoren und / oder integrierte Schaltungen angeordnet werden können.

Vorzugsweise sind die Druckelemente derart angeordnet, dass sie an oder nahe benachbart der Stellen auf die Leiterplatte drücken, an denen auf der gegenüberliegenden Hauptfläche die Kontaktstellen der Anschlussleiter angeordnet sind.

Vorteilhaft an der erfindungsgemäßen Ausgestaltung des Leistungshalbleitermoduls ist somit, dass auf dem von dem Druckstück überragten Bereich der Leiterplatte Bauelemente angeordnet werden können und somit der gesamte Flächenbedarf dieser Leiterplatte auf Grund der besseren Ausnutzung geringer ist als bei einer Anordnung nach dem Stand der Technik.

Vorzugsweise wird das Druckstück derart ausgebildet, dass es mindestens eine seine beiden Hauptflächen verbindende Ausnehmung aufweist und die Druckelemente derart angeordnet sind, dass eine Konvektionsströmung von mindestens einem Rand des Druckelements zu dieser Ausnehmung möglich ist. Dies ist vorteilhaft, da hierdurch die zwischen der Leitplatte und dem Druckstück angeordneten Bauelemente effektiv gekühlt werden.

Die Erfindung wird anhand von Ausführungsbeispielen in Verbindung mit den Fig. 1 bis 3 näher erläutert.
- Fig. 1: zeigt in dreidimensionaler Darstellung ein Leistungshalbleitermodul mit einem erfindungsgemäßen Druckstück.
- Fig. 2: zeigt den Schnitt durch ein Leistungshalbleitermodul mit erfindungsgemäßen Druckstück.
- Fig. 3: zeigt in dreidimensionaler Darstellung eine weitere Ausgestaltung eines erfindungsgemäßen Druckstücks.

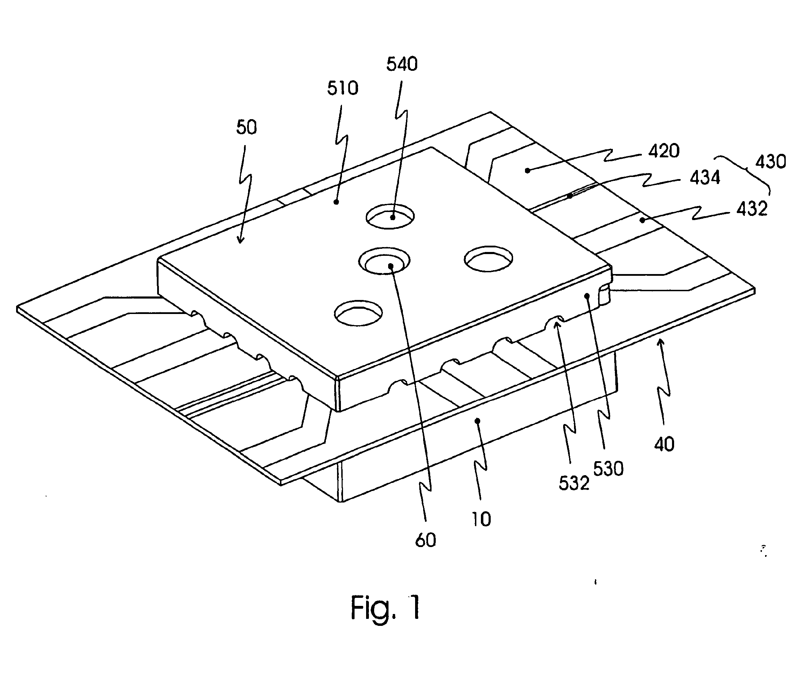

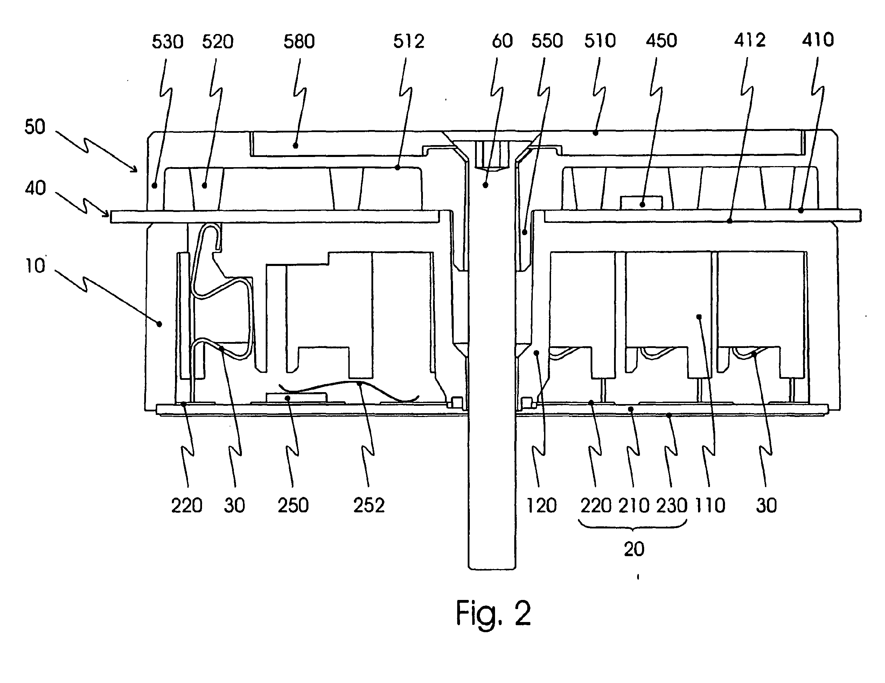

Fig. 1 zeigt in dreidimensionaler Darstellung ein Leistungshalbleitermodul mit einem erfindungsgemäßen Druckstück. Das Leistungshalbleitermodul bzw. dessen Gehäuse (10) ist unterhalb einer Leiterplatte (40) angeordnet. Die dem Gehäuse (10) zugewandte zweite Hauptfläche der Leiterplatte (40) trägt ebenso wie die erste Hauptfläche (410, siehe Fig. 2) externe Verbindungsbahnen (430), die als Laststromanschlussbahnen (432) und / oder als Hilfs- bzw. Steueranschlussbahnen (434) ausgeführt sind. Eine Mehrzahl dieser Anschlussbahnen kontaktiert mittels Kontaktflächen und / oder Durchkontaktierungen der Leiterplatte (40) die Anschlussleiter des Leistungshalbleitermoduls.

Auf der ersten Hauptfläche (410) der Leitplatte (40) ist ein Druckstück (50) aus einem elektrisch isolierenden formstabilen Kunststoff angeordnet, welches mittels einer Schraubverbindung (60) die durch Ausnehmungen der Leiterplatte, des Gehäuses sowie des Substrates mit einem Kühlkörper verbunden ist. Mittels dieser Verbindung wird die Druckkontaktierung der elektrischen Anschlüsse zwischen der Leiterplatte und den Anschlussleitern sowie der thermische Kontakt zwischen dem Substrat und dem Kühlkörper hergestellt. Das Druckstück weist zur Beabstandung seiner zweiten, der Leiterplatte zugewandten Hauptfläche von dieser Leiterplatte stegartige Druckelemente (530), die hier durch ihre Verbindung einen Rahmen bilden, auf. Somit ist die Anordnung von Bauelementen, wie beispielhaft Kondensatoren, zwischen der ersten Hauptfläche der Leiterplatte und der zweiten Hauptfläche des Druckstücks möglich. Zur Kühlung dieser Bauelemente weisen die stegartigen Druckelemente (530) Ausnehmungen (532) auf. Durch diese kann Kühlluft unter das Druckstück gelangen. Die die beiden Hauptflächen (510, 512) des Druckstücks verbindenden Ausnehmungen (540) verbessern die Kühlwirkung durch eine Konvektionsströmung von den Ausnehmungen (532) zu diesen Ausnehmungen (540).

Fig. 2 zeigt den Schnitt durch ein Leistungshalbleitermodul zur direkten Montage auf einem nicht dargestellten Kühlkörper sowie einem erfindungsgemäßen Druckstück (40). Das Leistungshalbleiterbauelement besteht aus einem Gehäuse (10) mit mindestens einem darin angeordneten elektrisch isolierenden Substrat (20), vorzugsweise einem sog. DCB (direct copper bonding) Substrat nach dem Stand der Technik. Dieses Substrat (20) besteht seinerseits aus einem keramischen Isolierstoffkörper (210) mit einer Mehrzahl auf seiner ersten Hauptfläche befindlicher gegeneinander isolierter metallischer Verbindungsbahnen (220) sowie einer auf seiner zweiten Hauptfläche angeordneten flächigen metallischen Schicht (230). Auf den Verbindungsbahnen (220) der ersten Hauptfläche und mit diesen schaltungsgerecht mittels Drahtbondverbindungen (252) verbunden sind eine Mehrzahl von Leistungshalbleiterbauelementen (250) angeordnet.

Als Anschlusselemente sowohl für Last- als auch für Steueranschlüsse weist das Leistungshalbleitermodul zumindest teilweise federnd gestaltete Anschlussleiter (30) auf. Diese Anschlussleiter sind innerhalb des Gehäuses (10) in Führungen (110) angeordnet. Die Anschlussleiter (30) stellen die elektrische Verbindung der Verbindungsbahnen (220) mit einer außerhalb des Gehäuses (10) angeordneten Leiterplatte (40) und den darauf angeordneten externen Verbindungsbahnen her. Der sichere elektrische Kontakt zwischen den Anschlussleitern (30) und den externen Verbindungsbahnen der Leiterplatte (40) wird jeweils mittels einer Anordnung in Druckkontaktierung erzielt. Die Druckeinleitung dieser Anordnung erfolgt mittels eines mit dem unterhalb des Substrates angeordneten, nicht dargestellten, Kühlkörper verbundenen formstabilen Druckstücks (50). Diese Verbindung ist als Schraubverbindung ausgebildet, wobei das Gehäuse (10) eine Führung (120) für diese Schraubverbindung aufweist.

Das Druckstück (50) dient der Druckkontaktierung der elektrischen Verbindung zwischen den Anschlussleitern (430, siehe Fig. 1), der Leiterplatte (40) und den Anschlussleitern (30) sowie zwischen den Anschlussleitern (30) und den Leiterbahnen (220) des Substrats (20) und zur thermischen Kontaktierung des Substrates (20) mit dem Kühlkörper. Hierzu weist das Druckstück (50) an seiner zweiten der Leitplatte zugewandten Hauptfläche (512) eine Mehrzahl von einzelnen und / oder miteinander verbundenen Druckelementen (520, 530) auf. Diese Druckelemente können beispielhaft als Stege (530) oder Finger (520) ausgebildet sein. Mittels dieser Druckelemente (520, 530) ist die zweite Hauptfläche (512) des Druckelements (50) von der ersten Hauptfläche (410) der Leiterplatte (40) derart beabstandet, dass auf dieser ersten, dem Druckstück (40) zugewandten Hauptfläche der Leiterplatte (410) Bauelemente (450), wie Widerstände Kondensatoren und / oder integrierte Schaltungen angeordnet werden können.

Die Druckelemente (520, 530) selbst sind derart angeordnet, dass sie einerseits an oder nahe benachbart denjenigen Stellen auf die Leiterplatte (40) drücken, an denen auf der gegenüberliegenden zweiten Hauptfläche (412) die Kontaktstellen der Anschlussleiter (30) angeordnet sind und anderseits einen Rahmen bilden, der über die Leiterplatte auf den Rand des Gehäuses (10) drückt. Weiterhin weist das Druckstück (50) eine Hülse (550) zur elektrisch isolierten Aufnahme der Schraubverbindung (60) zwischen dem Druckstück (50) und dem Kühlkörper auf.

Das Druckstück (50) besteht aus einem Verbund aus einem formstabilen elektrisch isolierenden Kunststoff und einer Metallseele (580), wobei die Metallseele in den Kunststoff eingespritzt und damit von ihm umhüllt oder in eine Aussparung eingelegt sein kann. Somit wird die Stabilität bei gleichzeitig geringer Dicke zwischen den beiden Hauptflächen (510, 512) des Druckstücks (50) gewährleistet. Zusätzlich können auf der ersten Hauptfläche (510) stegartige Versteifungsstrukturen angeordnet sein.

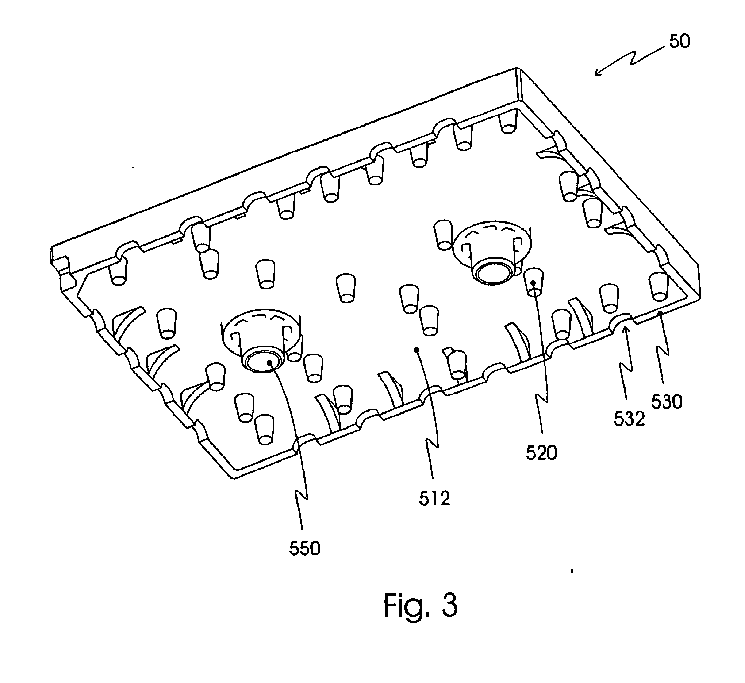

Fig. 3 zeigt in dreidimensionaler Darstellung eine weitere Ausgestaltung eines erfndungsgemäßen Druckstücks (50) mit Sicht auf die zweite Hauptfläche (512). Das

Druckstück (50) weist auf dieser zweiten Hauptfläche (512) eine Mehrzahl von fingerartigen Druckelementen (520) auf. Die ebenfalls derart angeordneten stegartigen Druckelemente (530) sind miteinander

verbunden und bilden durch ihre Anordnung einen Rand des Druckstücks. Diese stegartigen Druckstücke (530) weisen weiterhin Ausnehmungen (532) auf, die als Kühlluftöffnungen für im Bereich unterhalb der ersten Hauptfläche (512) des Druckelements (50) angeordnete Bauelemente, dienen.

Weiterhin weist das Druckstück (50) zwei Hülsen (550) zur Aufnahmen von Schraubverbindungen auf. Eine Mehrzahl derartiger Schraubverbindungen ist ab einer bestimmten lateralen Ausdehnung des Leistungshalbleitermoduls sinnvoll um eine sichere Druckeinleitung sowohl für die elektrischen Kontaktierungen als auch für die thermische Kontaktierung zu gewährleisten.

## Patentansprüche

1. Anordnung in Druckkontaktierung mit einem Leistungshalbleitermodul mit Grundplatte oder zur direkten Montage auf einem Kühlkörper, bestehend aus einem Gehäuse (10), mindestens einem elektrisch isolierenden Substrat (20), seinerseits bestehend aus einem Isolierstoffkörper (210) mit einer Mehrzahl darauf befindlicher gegeneinander isolierter metallischer Verbindungsbahnen (220), darauf befindlichen und mit diesen Verbindungsbahnen schaltungsgerecht verbundenen Leistungshalbleiterbauelementen (250) sowie zumindest teilweise federnd ausgestalteten Anschlussleitern (30) zur elektrischen Verbindung der Verbindungsbahnen (220) mit einer außerhalb des Gehäuses (10) angeordneten Leiterplatte (40) und mindestens einem formstabilen Druckstück (50) zur Druckkontaktierung der Leiterplatte (40) mit den Anschlussleitern (30),
wobei
das Druckstück (50) aus einem Verbund aus einem elektrisch isolierenden Kunststoff und einer Metallseele (580) besteht und an seiner der Leiterplatte (40) zugewandten Hauptfläche (512) eine Mehrzahl von Druckelementen (520, 530) aufweist, die diese Hauptfläche von der Leiterplatte (40) beabstanden, die als Stege und Finger ausgebildet sind, und die derart angeordnet sind, dass sie am oder nahe benachbant der Stellen auf die Leiterplatte drücken, an denen auf der gegenüberliegenden Hauptfläche die Kontaktstellen der Anschlussleiter angeordnet sind.

2. Anordnung nach Anspruch 1, wobei
das Druckstück (50) mindestens eine seine beiden Hauptflächen (510, 512) verbindende Ausnehmung (540) aufweist und die Druckelemente (520, 530) derart angeordnet sind, dass eine Konvektionsströmung von mindestens einem Rand des Druckelements (50) zu dieser Ausnehmung (540) möglich ist.

3. Anordnung nach Anspruch 1, wobei
das Druckstück (50) mindestens eine elektrisch isolierte Hülse (550) zur Aufnahme einer Schraubverbindung (60) aufweist.

4. Anordnung nach Anspruch 1, wobei
zumindest zwei Stege (530) der Druckelemente zusammenhängend ausgebildet sind und teilweise einen Rahmen bilden.

5. Anordnung nach Anspruch 1, wobei
die Stege (530) Ausnehmungen (532) zur Durchströmung aufweisen

## Claims

1. An arrangement in pressure contact with a power semiconductor module with a baseplate, or for direct mounting onto a cooling body, consisting of a housing (10), at least one electrically insulating substrate (20), for its part consisting of a body of insulating material (210) with a multiplicity of metallic connecting tracks (220) insulated from one another located on its first main surface, power semiconductor components (250) located thereon and connected with these connecting tracks in a manner appropriate to the circuit, as well as connecting terminals (30) configured at least partially in a sprung manner to establish electrical connection of the connecting tracks (220) with a printed circuit board arranged outside the housing (10), and at least one dimensionally stable pressure pad (50) to establish pressure contact between the printed circuit board (40) and the connecting terminals (30), wherein
the pressure pad (50) consists of a composite of an electrically insulating plastic and a metal core (580), and on its main surface (512) facing towards the printed circuit board (40) has a multiplicity of pressure elements (520, 530), which maintain a separation distance between this main surface and the printed circuit board (40); these are designed as webs and fingers and are arranged such that they press on or near to points on the printed circuit board at which the contact points of the connecting terminals are arranged on the opposite main surface.

2. The arrangement according to Claim 1, wherein
the pressure pad (50) has at least one opening (540) connecting its two main surfaces (510, 512), and the pressure elements (520, 530) are arranged such that a convective flow is possible from at least one edge of the pressure element (50) to this opening (540).

3. The arrangement according to Claim 1, wherein
the pressure pad (50) has at least one electrically insulating sleeve (550) to accommodate a screw connection (60).

4. The arrangement according to Claim 1, wherein
at least two webs (530) of the pressure elements are designed in a connected manner and partially form a frame.

5. The arrangement according to Claim 1, wherein
the webs (530) have openings (532) to allow flow to pass through.

## Revendications

1. Agencement dans un contact par pression comprenant un module à semi-conducteurs de puissance avec une plaque de base ou destiné au montage direct sur un corps réfrigérant, constitué d'un boîtier (10), d'au moins un substrat (20) électro-isolant, constitué pour sa part d'un corps isolant (210) avec une pluralité de bandes de liaison (220) métalliques, se trouvant dessus et isolées les unes par rapport aux autres, des composants à semi-conducteurs de puissance (250) se trouvant dessus et reliés à ces bandes de liaison de façon adaptée au montage et des conducteurs de branchement (30) conçus au moins en partie de façon élastique pour la liaison électrique des bandes de liaison (220) avec une plaquette de circuits imprimés (40) disposée à l'extérieur du boîtier (10) et au moins une pièce de pression (50) indéformable pour un contact par pression de la plaquette de circuits imprimés (40) avec les conducteurs de branchement (30),
la pièce de pression (50) étant constituée d'un assemblage d'une matière synthétique électro-isolante et d'une âme en métal (580) et présentant sur sa surface principale (512), tournée vers la plaquette de circuits imprimés (40), une pluralité d'éléments de pression (520, 530), qui maintiennent cette surface principale à distance de la plaquette de circuits imprimés (40), lesquels sont conçus sous forme d'entretoises et de doigts et sont disposés de telle sorte qu'ils appuient sur ou à proximité des endroits sur la plaquette de circuits imprimés sur lesquels sont disposés les points de contact des conducteurs de branchement sur la surface principale opposée.

2. Agencement selon la revendication 1,
la pièce de pression (50) présentant au moins un évidement (540) reliant ses deux surfaces principales (510, 51) et les éléments de pression (520, 530) étant disposés de telle sorte qu'un écoulement de convection depuis au moins un bord de l'élément de pression (50) vers cet évidement (540) est possible.

3. Agencement selon la revendication 1,
la pièce de pression (50) présentant au moins une douille (550) isolée électriquement pour le logement d'un assemblage vissé (60).

4. Agencement selon la revendication 1,
au moins deux entretoises (530) des éléments de pression étant conçues de façon cohérente et formant en partie un cadre.

5. Agencement selon la revendication 1,
les entretoises (530) présentant des évidements (532) pour l'écoulement.
